# DEMANDE DE BREVET EUROPEEN

(11) **EP 4 465 298 A1**
(43) Date de publication de la demande: **20.11.2024**
(21) Numéro de dépôt: 24174248.5
(22) Date de dépôt: 06.05.2024
(51) Int. Cl.: G11C 11/56, G11C 13/00

(54) **LECTURE D'UN DISPOSITIF DE MÉMOIRE NON VOLATILE MULTI-NIVEAUX, EN PARTICULIER À CHANGEMENT DE PHASE, ET DISPOSITIF DE MÉMOIRE NON VOLATILE MULTI-NIVEAUX**

(30) Priorité: 19.05.2023 FR 2304987
(71) Demandeur: STMicroelectronics International N.V., 1228 Plan-les-Ouates, Geneva (CH)
(72) Inventeur: LECOQ, Xavier, 38500 Voiron (FR); RAZAFINDRAIBE, Alin, 38400 Saint Martin d'Hères (FR)
(74) Mandataire: Casalonga

(57) **Abrégé**

Procédé de gestion du fonctionnement d'une cellule-mémoire non volatile multi-niveaux, la cellule-mémoire (MLB) comportant N niveaux, N étant pair et supérieur à deux, correspondant respectivement à N données logiques susceptibles d'être stockées dans la cellule-mémoire et à N plages de courants de lecture correspondantes, le procédé comprenant une lecture de la donnée stockée dans la cellule-mémoire comportant des comparaisons successives d'un courant de lecture (Iread) délivré par la cellule-mémoire avec des courants de référence (Iref) choisis dans un jeu de de N-1 courants de référence ayant des valeurs respectivement situées entre deux plages successives différentes, à l'aide d'un algorithme dichotomique commençant par le courant de référence ayant la valeur médiane.

## Description

Des modes de mise en oeuvre et de réalisation concernent les mémoires non volatiles multi-niveaux, notamment les mémoires à changement de phase (ou PCM : Phase Change Memory) ou encore les mémoires non volatiles à grille flottante, par exemple les mémoires FLASH ou bien les mémoires à transistor de sélection enterré, et plus particulièrement la lecture de telles mémoires.

Les mémoires non volatiles stockent généralement des données binaires sur deux niveaux correspondant aux deux valeurs logiques possibles « 0 » et « 1 » de ces données binaires.

Cependant il existe des mémoires multi-niveaux, ayant plus que deux niveaux, et susceptibles de stocker des données logiques capables de prendre plus que deux valeurs logiques.

Ceci permet d'obtenir des mémoires haute densité offrant un gain de place en raison de leur capacité à stocker un nombre plus élevé de données logiques, et pouvant par exemple être utilisées avantageusement dans des applications d'intelligence artificielle qui requièrent des réseaux de neurones artificiels (« ANN : Artificial Neural Network ») et des réseaux neuronaux convolutionnels (« CNN : Convolutional Neural Network »).

Il existe un besoin de proposer une solution permettant une lecture fiable, simple et rapide de telles mémoires multi-niveaux.

Selon un mode de mise en oeuvre et de réalisation, il est proposé de comparer le courant de lecture délivré par la mémoire avec des courants de référence successivement choisis en utilisant un algorithme dichotomique.

Selon un aspect il est proposé un procédé de gestion du fonctionnement d'une cellule-mémoire non volatile multi-niveaux.

La cellule-mémoire comporte N niveaux, N étant pair et supérieur à deux, correspondant respectivement à N données logiques susceptibles d'être stockées dans la cellule-mémoire et à N plages de courants de lecture correspondantes.

Le procédé selon cet aspect comprend une lecture de la donnée stockée dans la cellule-mémoire comportant des comparaisons successives d'un courant de lecture délivré par la cellule-mémoire avec des courants de référence choisis dans un jeu de N-1 courants de référence ayant des valeurs respectivement situées entre deux plages successives différentes, à l'aide d'un algorithme dichotomique commençant par le courant de référence ayant la valeur médiane.

La lecture peut comprendre une fourniture d'une source de courant réglable et des réglages successifs de la source de courant pour lui faire délivrer les courants de référence successivement choisis.

Cependant selon un mode de mode avantageux de mise en oeuvre, la lecture comprend un placement à côté de la cellule-mémoire, d'une cellule-mémoire de référence structurellement identique à la cellule-mémoire, et des lectures successives de cette cellule-mémoire de référence pour lui faire délivrer les courants de référence correspondants.

La cellule-mémoire est par exemple mais non exclusivement une cellule-mémoire du type à changement de phase.

Lorsque la cellule-mémoire de référence est à changement de phase, la délivrance d'un courant de référence comprend avantageusement le placement de la cellule-mémoire de référence dans un état initialisé et une application d'une tension de référence choisie sur la cellule-mémoire de référence pour lui faire délivrer le courant de référence correspondant.

Le procédé peut comprendre en outre une programmation de la cellule-mémoire au niveau souhaité et une vérification de la programmation en utilisant ladite lecture de la cellule-mémoire.

Lorsque la cellule-mémoire est à changement de phase, la programmation de la cellule-mémoire à un niveau inférieur au niveau maximum comprend avantageusement une programmation de la cellule-mémoire au niveau maximum puis des délivrances successives d'impulsions d'effacement de la cellule-mémoire respectivement suivies de lectures successives de la cellule-mémoire jusqu'à atteindre un courant de lecture correspondant au niveau de programmation souhaité.

Cela étant d'autres méthodologies de programmation de la cellule-mémoire à un niveau inférieur au niveau maximum, sont possibles.

Selon un autre aspect il est proposé un dispositif de mémoire non volatile multi-niveaux, comprenant (dans une architecture minimale) -au moins une cellule-mémoire non volatile comportant N niveaux, N étant pair et supérieur à deux, correspondant respectivement à N données logiques susceptibles d'être stockées dans la cellule-mémoire et à N plages de courants de lecture correspondantes, des moyens de lecture de la donnée stockée dans la cellule-mémoire configurés pour effectuer des comparaisons successives d'un courant de lecture délivré par la cellule-mémoire avec des courants de référence choisis dans un jeu de de N-1 courants de référence ayant des valeurs respectivement situées entre deux plages successives différentes, à l'aide d'un algorithme dichotomique commençant par le courant de référence ayant la valeur médiane.

Selon un mode de réalisation, les moyens de lecture comprennent une cellule-mémoire de référence située à côté de la cellule-mémoire et structurellement identique à la cellule-mémoire et un module de lecture configuré pour effectuer des lectures successives de cette cellule-mémoire de référence pour lui faire délivrer les courants de référence correspondants.

Selon un mode de réalisation, les moyens de lecture comprennent une source de courant réglable et des moyens de contrôle configurés pour effectuer des réglages successifs de la source de courant pour lui faire délivrer les courants de référence successivement choisis.

Selon un mode de réalisation, la cellule-mémoire est à titre d'exemple non limitatif, une cellule-mémoire du type à changement de phase.

Selon un mode de réalisation, la cellule-mémoire de référence du type à changement de phase est dans un état initialisé et le module de lecture est configuré pour appliquer une tension de référence choisie sur la cellule-mémoire de référence pour lui faire délivrer le courant de référence correspondant.

Selon un mode de réalisation, le dispositif comprend en outre des moyens de traitement configurés pour effectuer une programmation de la cellule-mémoire au niveau souhaité et effectuer une vérification de la programmation en utilisant ladite lecture de la cellule-mémoire.

Lorsque la cellule-mémoire est à changement de phase, les moyens de traitement sont avantageusement configurés pour effectuer une programmation de la cellule-mémoire à un niveau inférieur au niveau maximum en effectuant une programmation de la cellule-mémoire au niveau maximum puis en effectuant des délivrances successives d'impulsions d'effacement de la cellule-mémoire respectivement suivies de lectures successives de la cellule-mémoire jusqu'à atteindre un courant de lecture correspondant au niveau de programmation souhaité.

Cela étant les moyens de traitement peuvent être configurés pour appliquer d'autres méthodologies de programmation de la cellule-mémoire à un niveau inférieur au niveau maximum.

D'autres avantages et caractéristiques de l'invention apparaîtront à l'examen de la description détaillée de modes de mise en oeuvre et de réalisation nullement limitatifs, et des dessins annexés sur lesquels :
- [Fig.1],
- [Fig.2],
- [Fig.3],
- [Fig.4],
- [Fig.5],
- [Fig.6],
- [Fig.7],
- [Fig.8],
- [Fig.9],
- [Fig.10],
- [Fig.11],
illustrent schématiquement des modes de mise en oeuvre et de réalisation de l'invention.

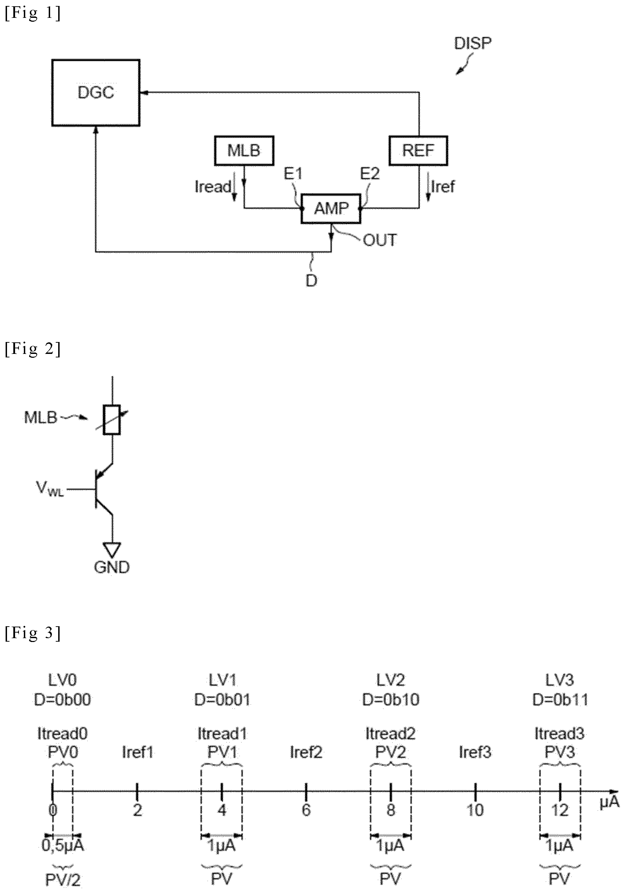

Sur la figure 1 la référence DISP désigne un dispositif de mémoire non volatile multi-niveaux, comprenant au moins une cellule-mémoire non volatile MLB comportant N niveaux, N étant pair et supérieur à deux.

N est par exemple mais non limitativement égal à 4.

Ces niveaux correspondent respectivement à N données logiques susceptibles d'être stockées dans la cellule-mémoire et à N plages de courants de lecture correspondantes.

Par exemple lorsque N est égal à 4, les 4 données logiques correspondantes peuvent être égales respectivement, en notation hexadécimale, à 0b00, 0b01, 0b10 et 0b11.

Le dispositif DISP comprend également des moyens de lecture de la donnée stockée dans la cellule-mémoire, configurés comme on le verra plus en détails ci-après, pour effectuer des comparaisons successives d'un courant de lecture Iread délivré par la cellule-mémoire MLB avec des courants de référence Iref choisis dans un jeu de de N-1 courants de référence ayant des valeurs respectivement situées entre deux plages successives différentes, à l'aide d'un algorithme dichotomique commençant par le courant de référence ayant la valeur médiane.

Chaque courant de référence est délivré par un moyen de référence REF réglable, dont on reviendra plus en détails ci-après sur une structure possible.

Les moyens de lecture comprennent ici, outre le moyen de référence REF, une unité de traitement DGC, par exemple un microcontrôleur, capable de régler le moyen de référence REF, et de récupérer une information représentative de la donnée D stockée dans la cellule-mémoire MLB.

Cette information est délivrée par un amplificateur de lecture classique AMP, faisant partie des moyens de lecture, et comportant une première entrée E1 connectée à la cellule-mémoire MLB pour recevoir le courant de lecture Iread, une deuxième entrée E2 connectée au moyen de référence REF pour recevoir le courant de référence Iref, et une sortie OUT destinée à délivrer l'information représentative de la donnée stockée D.

Bien que la cellule-mémoire puisse être tout type de cellule-mémoire non volatile, par exemple une cellule-mémoire du type à grille flottante et transistor de sélection enterré, ou bien une cellule-mémoire du type mémoire morte électriquement effaçable et programmable (EEPROM), on va maintenant décrire un mode de mise en oeuvre et de réalisation dans lequel, sauf mention contraire, la cellule-mémoire MLB est du type à changement de phase.

Comme il est bien connu de l'homme du métier, les mémoires à changement de phase sont des mémoires non volatiles s'appuyant sur les propriétés des matériaux à changement de phase.

Un matériau à changement de phase a, en effet, la capacité de basculer d'un état faiblement résistif à un état résistif grâce à son échauffement.

Les mémoires à changement de phase tirent profit du fait que les résistances électriques des différents états des matériaux à changement de phase sont différentes afin de stocker des données.

Plus précisément, lorsque la mémoire est destinée à stocker une valeur logique binaire ayant deux états logiques, le matériau à changement de phase a la capacité de basculer d'un état résistif (HRS, High Résistif State) à un état faiblement résistif (LRS, Low Résistif State) sous l'effet de la chaleur et de l'effet Joule généré par l'application d'un courant entre des électrodes.

Le basculement d'un état résistif à un état faiblement résistif correspond à une opération de programmation ou d'activation dite « SET » c'est-à-dire une opération d'écriture d'une valeur de donnée binaire, par exemple d'une valeur logique 1.

La mémoire est alors dans un état dit « initialisé » (SET).

Le basculement d'un état faiblement résistif à l'état résistif correspond à une opération d'effacement ou de désactivation dite « RESET », c'est-à-dire une opération d'écriture d'une valeur de donnée binaire opposée, par exemple d'une valeur logique 0.

La mémoire est alors dans un état dit « réinitialisé » (RESET).

Pour effectuer une opération de programmation ou SET, le matériau à changement de phase est chauffé entre ses températures de cristallisation et de fusion puis refroidi lentement afin d'obtenir une phase cristalline. L'impulsion de courant présente donc une décroissance lente.

Par contre, pour rendre le matériau à changement de phase amorphe (opération d'effacement ou RESET) il est chauffé au-dessus de sa température de fusion puis refroidi rapidement afin de figer à l'état amorphe à température ambiante. L'impulsion de courant est donc très courte et abrupte.

Comme on le verra plus en détails ci-après, lorsque la mémoire est multi-niveaux, c'est-à-dire capable de stocker des données logiques pouvant prendre N valeur logiques différentes, il est possible de prévoir pour la cellule-mémoire, des états intermédiaires entre l'état réinitialisé (RESET) et l'état initialisé (SET).

Ainsi lorsque N est égal à 4, on peut prévoir deux états intermédiaires correspondant respectivement à un état « partiellement réinitialisé » et à un état « partiellement initialisé ».

Les différents états de la cellule-mémoire vont se distinguer par la valeur du courant de lecture Iread délivré par la cellule-mémoire.

La figure 2 illustre schématiquement une structure classique et connue en soi de cellule-mémoire à changement de phase MLB.

Plus précisément, elle comporte un élément mémoire par exemple comportant du germanium, de l'antimoine et du tellure qui présentent des valeurs de résistance différentes en fonction des états réinitialisé/partiellement réinitialisé/partiellement initialisé/initialisé de la mémoire.

Cet élément mémoire est associé à un dispositif de chauffage, par exemple deux électrodes, qui lorsqu'il est parcouru par un courant chauffe l'élément de mémoire par effet joule pour faire varier sa résistance.

La cellule-mémoire MLB est associée à un transistor de sélection TS qui est ici un transistor bipolaire PNP connecté en série entre l'élément de mémoire et un point froid d'alimentation, typiquement la masse GND.

La base du transistor bipolaire est connectée sur une ligne de mots et est destinée à recevoir une tension V_{WL} rendant passant ce transistor de façon à permettre la circulation du courant dans le dispositif de chauffage de façon à chauffer l'élément de mémoire.

Bien entendu, le transistor bipolaire TS pourrait être remplacé par un transistor MOS, par exemple un transistor PMOS.

Une cellule-mémoire CEL dans un état initialisé (SET) est par exemple destinée à délivrer en lecture un courant Iread de l'ordre de 12 microampères.

Une cellule-mémoire CEL dans son état réinitialisé (RESET) est susceptible de délivrer un courant Iread nul ou quasi nul.

Une cellule-mémoire CEL dans son état partiellement réinitialisé est susceptible de délivrer par exemple un courant Iread de l'ordre de 4 microampères.

Une cellule-mémoire CEL dans son état partiellement initialisé est susceptible de délivrer par exemple un courant Iread de l'ordre de 8 microampères.

Ces courants sont obtenus en présence par exemple d'une tension appliquée sur l'élément de mémoire comprise entre 1,5 et 1,8 volts pour un transistor de sélection TS bipolaire et comprise entre 0,4 et 0,5 volt pour un transistor de sélection du type MOS.

La figure 3 illustre notamment ces différents courants de lecture.

En pratique et à titre d'exemple non limitatif, les valeurs de 0, 4, 8 et 12 microampères correspondent à des valeurs cibles de courants de lecture Itread0, Itread1, Itread2, Itread3.

En pratique les courants de lecture effectifs peuvent se situer dans des plages de valeurs PV1, PV2 et PV3 autour des valeurs cibles Itread1, Itread2, Itread3 et dans plage de valeurs PV0 débutant à la valeur cible Itread0.

Les plages de valeurs PV1-PV3 ont ici à des fins de simplification, une même amplitude PV et la plage de valeurs PV0 a une amplitude égale à PV/2.

Cette amplitude PV dépend en particulier de la sensibilité de l'amplificateur de lecture AMP et/ou d'une tolérance lors de la programmation/effacement de la cellule-mémoire.

A titre d'exemple non limitatif, l'amplitude PV peut être prise égale à 1 microampère.

Cela étant, en pratique dans le cas d'une cellule-mémoire à changement de phase, la plage PV peut dans certaines conditions, augmenter avec l'augmentation de la conductance.

Ainsi la plage de valeurs PV3 peut être supérieure à la plage de valeurs PV2 elle-même supérieure à la plage de valeurs PV1 elle-même supérieure à la plage de valeurs PV0.

Cependant pour des cellules-mémoires non volatiles à grille flottante, l'amplitude PV reste plus ou moins constante.

Comme illustré sur la figure 3, ces valeurs cibles et leur plage de valeurs associée définissent ici pour la cellule-mémoire MLB, quatre niveaux LV0, LV1, LV2 et LV3 respectivement associés aux quatre valeurs logiques suivantes de la donnée D : 00b0, 00b01, 00b10 et 00b11.

Trois courants de référence Iref1, Iref2, Iref3, destinés à être délivrés par le moyen de référence REF, sont définis ayant des valeurs situées entre les plages de valeurs PV0-PV3, par exemple au milieu des intervalles entre ces plages de valeurs.

Ainsi, ici les valeurs de ces courants de référence Iref1, Iref2, Iref3 sont égales respectivement à 2, 4 et 6 microampères.

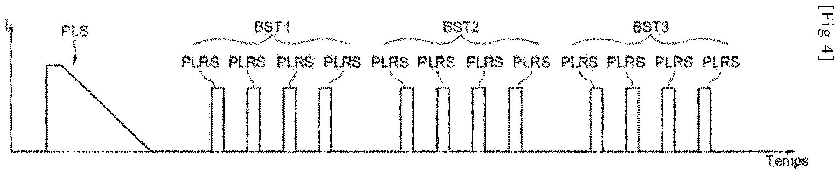

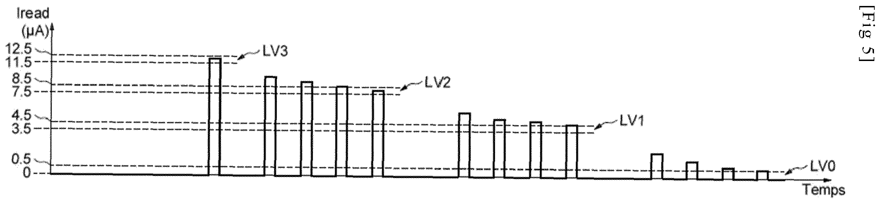

Les figures 4 et 5 illustrent un exemple de programmation de la cellule-mémoire MLB.

Cette programmation est faite sous le contrôle de moyens de traitement incorporés dans le microcontrôleur DGC.

Dans un premier temps on délivre une impulsion de programmation PLS (figure 4) à la cellule-mémoire de façon à la placer dans son état initialisé (SET).

La cellule mémoire a alors le niveau LV3 (figure 5) correspondant à un courant de lecture Iread compris entre 11,5 et 12,5 microampères.

Si l'on souhaite programmer la cellule-mémoire au niveau LV2, correspondant à un courant de lecture Iread compris entre 7,5 et 8,5 microampères, on délivre à la cellule-mémoire une salve BST1 d'impulsions d'effacement PLRS jusqu'à atteindre le courant de lecture désiré.

Si l'on souhaite programmer la cellule-mémoire au niveau LV1, correspondant à un courant de lecture Iread compris entre 4,5 et 3,5 microampères, on délivre à la cellule-mémoire une autre salve BST2 d'impulsions d'effacement PLRS jusqu'à atteindre le courant de lecture désiré.

Si l'on souhaite réinitialiser (RESET) la cellule-mémoire au niveau LV0, correspondant à un courant de lecture Iread compris entre 0,5 et 0 microampère, on délivre à la cellule-mémoire une autre salve BST3 d'impulsions d'effacement PLRS jusqu'à atteindre le courant de lecture désiré.

En pratique, après chaque impulsion d'effacement on effectue une lecture de la cellule-mémoire de la façon qui sera expliquée ci-après, pour vérifier le courant de lecture obtenu et décider si une autre impulsion d'effacement est nécessaire.

Cela étant d'autres schémas de programmation sont possibles.

Plus précisément on peut effectuer un premier cycle comportant une impulsion de programmation, suivie d'une impulsion d'effacement suivie d'une lecture de la cellule-mémoire. Si le courant de lecture désiré n'est pas obtenu, on recommence le même cycle mais avec une impulsion d'effacement d'amplitude plus ajustée. Et on répète ces cycles jusqu'à obtenir le courant de lecture désiré.

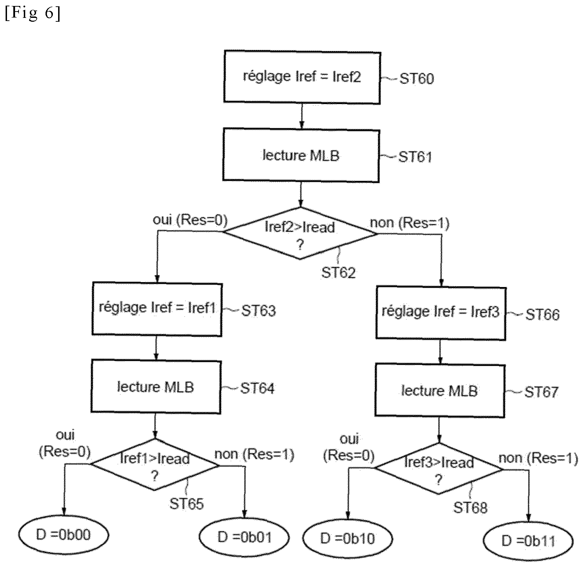

On se réfère maintenant plus particulièrement à la figure 6 pour décrire un mode de mise en oeuvre d'une lecture de la cellule-mémoire MLB pour déterminer la donnée logique qui y est stockée.

Le microcontrôleur DGC règle le moyen de référence de façon à lui faire délivrer le courant de référence Iref2 ayant valeur médiane parmi les valeurs du jeu de courants de référence Iref1-Iref3 (étape ST60).

Puis les moyens de lecture effectuent une lecture de la cellule-mémoire MLB (étape ST61) en appliquant une tension de lecture sur la cellule-mémoire de façon à lui faire délivrer le courant de lecture Iread.

L'amplificateur de lecture AMP compare ensuite (étape ST62) le courant de lecture Iread avec le courant de référence Iref2.

Si le courant de référence Iref2 est inférieur au courant Iread, alors le résultat Res délivré par l'amplificateur AMP correspond à un « 1 » logique.

Cela signifie que le courant de lecture Iread se situe dans l'intervalle situé à droite de Iref2 sur la figure 3.

Si le courant de référence Iref2 est supérieur au courant Iread, alors le résultat Res délivré par l'amplificateur AMP correspond à un « 0 » logique.

Cela signifie que le courant de lecture Iread se situe dans l'intervalle situé à gauche de Iref2 sur la figure 3.

Le microcontrôleur va alors mettre en oeuvre un algorithme dichotomique de façon à diminuer de moitié l'intervalle considéré et ainsi de suite de façon à obtenir la valeur de la donnée D stockée dans la cellule-mémoire.

Plus précisément, si dans l'étape ST62, le résultat Res vaut 1, le microcontrôleur va régler le moyen de référence REF de façon à ce qu'il délivre le courant de référence Iref3 (étape ST66).

Les moyens de lecture effectuent une nouvelle lecture de la cellule-mémoire MLB (étape ST67).

Le courant de lecture correspondant Iread est comparé dans l'amplificateur de lecture AMP avec le courant de référence Iref3.

Si Iref3 est inférieur à Iread, ce qui correspond à un résultat Res égal à « 1 », cela signifie que le courant Iread se situe dans l'intervalle situé à droite de Iref3 sur la figure 3.

En conséquence comme il n'y a plus d'intervalle à réduire de moitié et donc plus d'incertitude sur la valeur de la donnée logique, la donnée D a dans ce cas la valeur logique 0b11.

Si Iref3 est supérieur à Iread, ce qui correspond à un résultat Res égal à « 0 », cela signifie que le courant Iread se situe dans l'intervalle situé à gauche de Iref3 sur la figure 3.

En conséquence comme il n'y a plus d'intervalle à réduire de moitié et donc plus d'incertitude sur la valeur de la donnée logique, la donnée D a dans ce cas la valeur logique 0b10.

Plus précisément, si dans l'étape ST62, le résultat Res vaut 0, le microcontrôleur va régler le moyen de référence REF de façon à ce qu'il délivre le courant de référence Iref1 (étape ST63).

Les moyens de lecture effectuent une nouvelle lecture de la cellule-mémoire MLB (étape ST64).

Le courant de lecture correspondant Iread est comparé dans l'amplificateur de lecture AMP avec le courant de référence Iref1.

Si Iref1 est inférieur à Iread, ce qui correspond à un résultat Res égal à « 1 », cela signifie que le courant Iread se situe dans l'intervalle situé à droite de Iref1 sur la figure 3.

En conséquence comme il n'y a plus d'intervalle à réduire de moitié et donc plus d'incertitude sur la valeur de la donnée logique, la donnée D a dans ce cas la valeur logique 0b01.

Si Iref1 est supérieur à Iread, ce qui correspond à un résultat Res égal à « 0 », cela signifie que le courant Iread se situe dans l'intervalle situé à gauche de Iref1 sur la figure 3.

En conséquence comme il n'y a plus d'intervalle à réduire de moitié et donc plus d'incertitude sur la valeur de la donnée logique, la donnée D a dans ce cas la valeur logique 0b00.

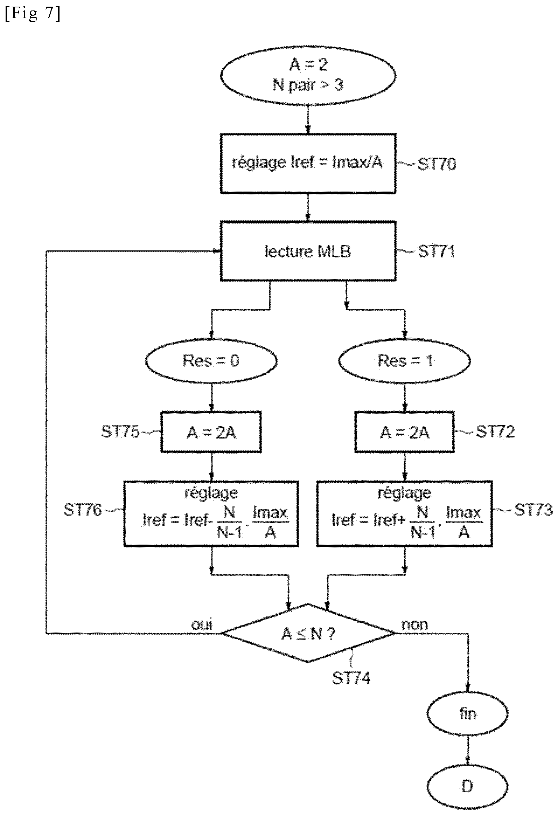

La figure 7 illustre la mise en oeuvre de l'algorithme dichotomique dans le cas général pour N pair et supérieur à 3.

L'algorithme utilise un paramètre A qui est initialisé à la valeur 2.

Le microcontrôleur règle le moyen de référence REF de façon à ce qu'il délivre un courant Iref égal à Imax/A (étape ST70).

Imax désigne la valeur maximale parmi les valeurs cibles des courants de lecture.

Dans le cas de la figure 6, Imax était la valeur du courant Itread3, soit 12 microampères.

Puis dans l'étape ST71, on procède à une lecture de la cellule-mémoire MLB.

Si le résultat Res est égal à 1, on double la valeur de A (étape ST72) et le microcontrôleur règle dans l'étape ST73, le moyen de référence REF de façon à ce qui délivre un courant Iref ayant la valeur précédente augmentée de N.Imax/A.(N-1).

Si le résultat Res est égal à 0, on double la valeur de A (étape ST75) et le microcontrôleur règle dans l'étape ST76, le moyen de référence REF de façon à ce qui délivre un courant Iref ayant la valeur précédente diminuée de N.Imax/A.(N-1).

Si dans l'étape ST74, A est inférieur ou égal à N, le microcontrôleur reboucle à l'étape ST71.

Si par contre A est supérieur à N, cela signifie que l'on effectué toute la dichotomie et que la valeur de la donnée D a été déterminée.

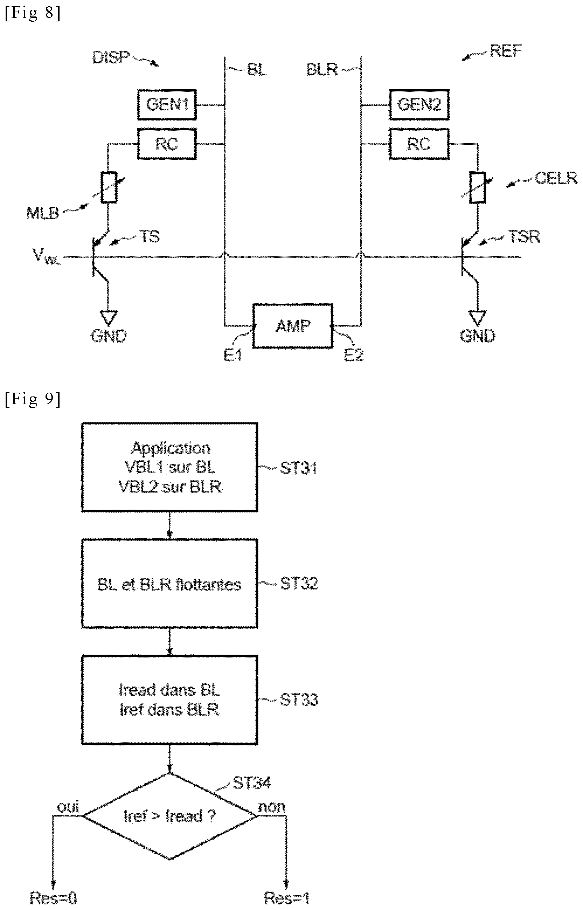

On se réfère maintenant plus particulièrement aux figures 8 et 9 pour décrire un mode de réalisation et de mise en oeuvre d'un moyen de référence REF.

Un tel mode de réalisation et de mise en oeuvre est décrit dans une autre demande de brevet français déposée au nom de la Demanderesse le même jour que la présente demande de brevet et ayant pour titre « Dispositif de mémoire du type à changement de phase et procédé de lecture d'un tel dispositif ».

L'homme du métier pourra se référer à toutes fins utiles à cette autre demande de brevet dont le contenu est incorporé à la présente demande de brevet.

On rappelle maintenant ici des caractéristiques de ce mode de réalisation et de mise en oeuvre, qui prévoit pour le moyen de référence REF l'utilisation d'une cellule-mémoire de référence CELR (figure 8) du type à changement de phase.

La cellule-mémoire MLB et la cellule-mémoire de référence CELR ont une structure identique et sont placées côte à côte.

La cellule-mémoire de référence est dans un état initialisé (SET) et un module de lecture est configuré pour appliquer une tension de référence choisie sur la cellule-mémoire de référence pour lui faire délivrer le courant de référence correspondant.

La base du transistor bipolaire de sélection TSR associé à la cellule-mémoire de référence CELR est également destinée à recevoir la tension V_{WL}.

Bien entendu, le transistor bipolaire TSR pourrait être remplacé par un transistor MOS, par exemple un transistor PMOS.

Le dispositif de mémoire DISP comporte également une ligne de bits BL associée à la cellule-mémoire MLB et une ligne de bits BRL associée à la cellule-mémoire de référence CELR.

La référence RC désigne les résistances et capacités parasites résultant des interconnexions entre les différents éléments du dispositif DISP.

Le module de lecture inclut un premier générateur de tension GEN1 et un deuxième générateur de tension GEN2 destinés à être connectés respectivement aux lignes de bits BL et BLR.

Par ailleurs, les lignes de bits BL et BLR sont respectivement connectées aux deux entrées E1 et E2 de l'amplificateur de lecture AMP.

La cellule-mémoire MLB est connectée à la ligne de bits BL tandis que la cellule de référence CELR est connectée à la ligne de bits BLR.

Le fait que la cellule-mémoire MLB et la cellule-mémoire de référence soient placées côte à côte permet que les tensions appliquées sur les bases de transistor de sélection TS et TSR soient sensiblement les mêmes et que les chemins de lecture de la cellule-mémoire MLB et les chemins de lecture de la cellule-mémoire de référence CELR soient correctement équilibrés.

A titre indicatif, on pourra choisir avantageusement une distance comprise entre 10 micromètres et 20 micromètres séparant la cellule-mémoire MLB et la cellule-mémoire de référence CELR pour une technologie 18 nanomètres.

Bien entendu cette valeur de distance n'est qu'un exemple et l'homme du métier saura ajuster cette valeur, si nécessaire, en fonction notamment des caractéristiques des cellules-mémoires et des schémas de lecture.

La lecture de la cellule CEL est une lecture à entrée unique (par opposition à une lecture différentielle) décrite en référence à la figure 9.

Dans une étape ST3 1, on applique tout d'abord une tension VBL1 sur la ligne de bits BL et une tension VBL2 sur la ligne de bits BLR.

Ces deux tensions VBL1 et VBL2 sont respectivement délivrées par les deux générateurs de courant GEN1 et GEN2.

La tension VBL1 est celle qui permet d'obtenir un courant correspondant à l'état initialisé de la cellule-mémoire MLB (typiquement 12 microampères).

Pour un transistor de sélection bipolaire on choisira une tension VBL1 comprise entre 1,5V et 1,8V.

La tension VBL2 est une tension inférieure ou égale à la tension VBL1, de façon à faire délivrer à la cellule-mémoire de référence CELR le courant de référence choisi.

A titre d'exemple, pour obtenir le courant de référence Iref 3 (10 microampères), on prendra, pour un transistor de sélection bipolaire, une tension VBL2 comprise entre 1,5V et 1,8V.

A titre d'exemple, pour obtenir le courant de référence Iref 2 (6 microampères), on prendra, pour un transistor de sélection bipolaire, une tension VBL2 comprise entre 1,35V et 1,7V.

A titre d'exemple, pour obtenir le courant de référence Iref 1 (2 microampères), on prendra, pour un transistor de sélection bipolaire, une tension VBL2 comprise entre 1,2V et 1,55V.

Une fois que les lignes de bits BL et BLR ont été polarisées avec des tensions VBL1 et VBL2 dans l'étape ST31, on rend les lignes de bits BL et BLR flottantes (étape ST32) par exemple en déconnectant les deux générateurs GEN1 et GEN2 des lignes de bits BL et BLR ou bien en les stoppant.

Les transistors TS et TSR étant passants, la cellule-mémoire MLB tire le courant Iread qui circule dans la ligne de bits BL tandis que la cellule-mémoire de référence CELR tire le courant de référence Iref qui circule dans la ligne de bit BLR (étape ST33).

Ces deux courants Iref et Iread sont comparés (étape ST34) dans l'amplificateur de lecture AMP.

Si le courant Iref est inférieur au courant Iread alors le résultat Res est égal à 1.

Si le courant Iread est supérieur au courant Iref, alors le résultat Res est égal à 0.

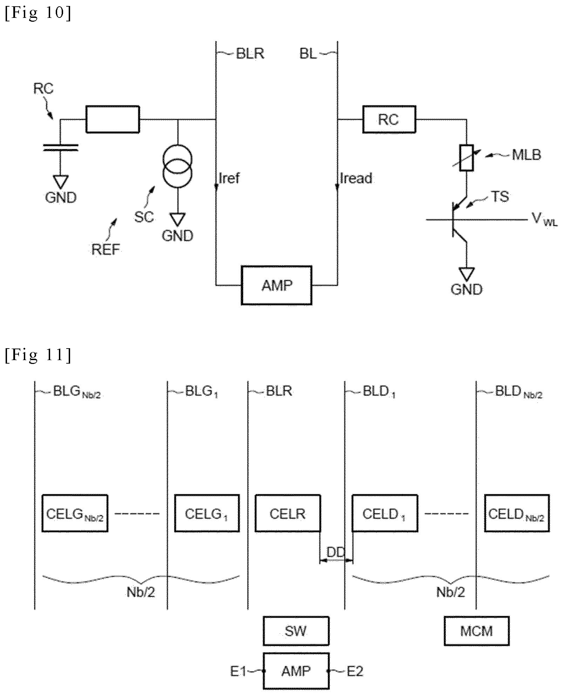

Il est également possible, comme illustré sur la figure 10, d'utiliser une source de courant réglable SC comme moyen de référence REF, au lieu d'une cellule-mémoire de référence CELR.

Le microcontrôleur DGC incorpore des moyens de contrôle capables de régler la source de courant SC pout lui faire délivrer le courant de référence choisi.

La source de courant SC tire alors un courant Iref (choisi parmi le jeu de courants Iref1-Iref3) dans la ligne de bits BLR tandis que la cellule-mémoire MLB tire un courant Iread dans la ligne de bits BL.

Les deux courants sont comparés dans l'amplificateur de lecture AMP.

Cependant la lecture à mode à entrée unique utilisant la cellule-mémoire de référence CELR est plus précise comparée à la méthode de lecture à entrée unique utilisant une source de courant car elle est moins sensible au décalage de résistance de la cellule-mémoire MLB et aux décalages structuraux observés entre une cellule-mémoire et une source de courant.

Généralement en pratique, le dispositif de mémoire comprend un plan mémoire comportant une matrice de cellules-mémoires organisées en lignes et en colonnes.

Ainsi, comme illustré sur la figure 11 sur laquelle les cellules-mémoires sont référencées avec la racine CEL, une ligne de cellules-mémoires comporte des groupes de plusieurs cellules-mémoires.

A des fins de simplification la figure 11 illustre un seul groupe de plusieurs cellules-mémoires CELGᵢ et CELDᵢ respectivement couplées à la première entrée E1 de l'amplificateur de lecture AMP par l'intermédiaire d'interrupteurs commandables SW.

Une seule cellule-mémoire de référence CELR est associée à ce groupe de cellules-mémoires CEL.

Ceci offre un gain de place appréciable sur silicium.

Et cette cellule-mémoire de référence est connectée à la deuxième entrée E2 de l'amplificateur de lecture comme indiqué ci-avant.

Des moyens de commande MCM, par exemple un circuit logique, sont alors configurés pour sélectionner successivement lesdits interrupteurs SW de façon que les moyens de lecture puissent lire successivement chaque cellule-mémoire CEL comme expliqué ci-avant.

En pratique, on pourra choisir par exemple des groupes de Nb cellules-mémoires associés à une seule cellule-mémoire de référence CELR.

Et, de façon à ne pas trop éloigner les cellules-mémoires de ce groupe de la cellule-mémoire de référence, on choisira un nombre Nb de cellules-mémoires partitionné en deux sous-groupes de Nb/2 cellules-mémoires.

Et, comme illustré sur la figure 11, la cellule-mémoire de référence CELR est encadrée par un premier sous-groupe de Nb/2 cellules-mémoires CELG₁-CELG_{Nb/2} et par un deuxième groupe de Nb/2 cellules-mémoires CELD₁-CELD_{Nb/2}.

La distance DD entre chaque cellule-mémoire CELG₁-CELD₁ immédiatement adjacente à la cellule-mémoire de référence est comme indiqué ci-avant préférentiellement de l'ordre de 10 à 20 microns.

Et, l'homme du métier choisira la valeur de Nb/2 de façon que les cellules-mémoires CELG_{Nb/2}-CELD_{Nb/2} les plus éloignées de la cellule de référence ne soient pas trop impactées par une distance trop importante vis-à-vis de la cellule-mémoire de référence CELR.

On pourra par exemple choisir sur chaque ligne du plan mémoire des groupes de 8 cellules-mémoires.

Chaque groupe est alors associé à une cellule de référence encadré à gauche et à droite par 4 cellules-mémoires.

Et, par exemple on lit d'abord la première cellule de gauche MLBG₁ puis successivement les autres cellules de gauche jusqu'à lire la cellule MLBG_{Nb/2}.

Puis, on lit la première cellule de droite MLBD₁ puis successivement les autres cellules de droite jusqu'à lire la cellule MLBD_{Nb/2}.

Bien entendu tout autre ordre de lecture est possible.

Comme indiqué ci-avant l'invention, et en particulier la lecture utilisant un algorithme dichotomique s'applique à tout type de mémoire non volatile multi-niveaux, par exemple à une mémoire à grille flottante et transistor de sélection enterré dans le substrat semiconducteur.

Cependant pour un tel type de mémoire, la programmation des différents niveaux s'effectue en effaçant totalement la mémoire pour obtenir le niveau LV0 puis en programmant successivement la mémoire pour obtenir les niveaux LV1 et suivants jusqu'à obtenir le niveau souhaité.

C'est donc l'inverse de ce qui est fait pour une mémoire à changement de phase où on programme tout d'abord la mémoire au niveau le plus élevé (SET) puis on efface progressivement la mémoire pour obtenir les niveaux inférieurs jusqu'à obtenir le niveau souhaité.

## Revendications

1. Procédé de gestion du fonctionnement d'une cellule-mémoire non volatile multi-niveaux, la cellule-mémoire (MLB) comportant N niveaux, N étant pair et supérieur à deux, correspondant respectivement à N données logiques susceptibles d'être stockées dans la cellule-mémoire et à N plages de courants de lecture correspondantes, le procédé comprenant une lecture de la donnée stockée dans la cellule-mémoire comportant des comparaisons successives d'un courant de lecture (Iread) délivré par la cellule-mémoire avec des courants de référence (Iref) choisis dans un jeu de de N-1 courants de référence ayant des valeurs respectivement situées entre deux plages successives différentes, à l'aide d'un algorithme dichotomique commençant par le courant de référence ayant la valeur médiane.

2. Procédé selon la revendication 1, dans lequel la lecture comprend un placement à côté de la cellule-mémoire, d'une cellule-mémoire de référence (CELR) structurellement identique à la cellule-mémoire, et des lectures successives de cette cellule-mémoire de référence pour lui faire délivrer les courants de référence correspondants.

3. Procédé selon la revendication 1, dans lequel la lecture comprend une fourniture d'une source de courant réglable (SC) et des réglages successifs de la source de courant pour lui faire délivrer les courants de référence successivement choisis.

4. Procédé selon l'une des revendications précédentes, dans lequel la cellule-mémoire (MLB) est une cellule-mémoire du type à changement de phase.

5. Procédé selon les revendications 2 et 4, dans lequel la cellule-mémoire de référence (CELR) est à changement de phase et la délivrance d'un courant de référence comprend le placement de la cellule-mémoire de référence dans un état initialisé et une application d'une tension de référence choisie sur la cellule-mémoire de référence pour lui faire délivrer le courant de référence correspondant.

6. Procédé selon l'une des revendications précédentes, comprenant en outre une programmation de la cellule-mémoire (MLB) au niveau souhaité et une vérification de la programmation en utilisant ladite lecture de la cellule-mémoire.

7. Procédé selon les revendications 4 et 6, dans lequel la programmation de la cellule-mémoire à un niveau inférieur au niveau maximum comprend une programmation (PLS) de la cellule-mémoire au niveau maximum puis des délivrances successives d'impulsions d'effacement (PLRS) de la cellule-mémoire respectivement suivies de lectures successives de la cellule-mémoire jusqu'à atteindre un courant de lecture correspondant au niveau de programmation souhaité.

8. Dispositif de mémoire non volatile multi-niveaux, comprenant au moins une cellule-mémoire non volatile (MLB) comportant N niveaux, N étant pair et supérieur à deux, correspondant respectivement à N données logiques susceptibles d'être stockées dans la cellule-mémoire et à N plages de courants de lecture correspondantes, des moyens de lecture (DGC, CELR, GEN1, GEN2, AMP) de la donnée (D) stockée dans la cellule-mémoire configurés pour effectuer des comparaisons successives d'un courant de lecture délivré par la cellule-mémoire avec des courants de référence choisis dans un jeu de de N-1 courants de référence ayant des valeurs respectivement situées entre deux plages successives différentes, à l'aide d'un algorithme dichotomique commençant par le courant de référence ayant la valeur médiane.

9. Dispositif selon la revendication 8, dans lequel les moyens de lecture comprennent une cellule-mémoire de référence (CELR) située à côté de la cellule-mémoire et structurellement identique à la cellule-mémoire, et un module de lecture (GEN1, GEN2) configuré pour effectuer des lectures successives de cette cellule-mémoire de référence pour lui faire délivrer les courants de référence correspondants.

10. Dispositif selon la revendication 8, dans lequel les moyens de lecture comprennent une source de courant réglable (SC) et des moyens de contrôle (DGC) configurés pour effectuer des réglages successifs de la source de courant pour lui faire délivrer les courants de référence successivement choisis.

11. Dispositif selon l'une des revendications 8 à 10, dans lequel la cellule-mémoire (MLB) est une cellule-mémoire du type à changement de phase.

12. Dispositif selon les revendications 9 et 11, dans lequel la cellule-mémoire de référence (CELR) du type à changement de phase est dans un état initialisé et le module de lecture est configuré pour appliquer une tension de référence choisie sur la cellule-mémoire de référence pour lui faire délivrer le courant de référence correspondant.

13. Dispositif selon l'une des revendications 8 à 12, comprenant en outre des moyens de traitement (DGC) configurés pour effectuer une programmation de la cellule-mémoire au niveau souhaité et effectuer une vérification de la programmation en utilisant ladite lecture de la cellule-mémoire.

14. Dispositif selon les revendications 11 et 13, dans lequel les moyens de traitement sont configurés pour effectuer une programmation de la cellule-mémoire (MLB) à un niveau inférieur au niveau maximum en effectuant une programmation de la cellule-mémoire au niveau maximum puis en effectuant des délivrances successives d'impulsions d'effacement de la cellule-mémoire respectivement suivies de lectures successives de la cellule-mémoire jusqu'à atteindre un courant de lecture correspondant au niveau de programmation souhaité.
